(19) Europäisches Patentamt
European Patent Office
Office européen des brevets

(11) EP 0 485 853 B1

## (12) EUROPÄISCHE PATENTSCHRIFT

(45) Veröffentlichungstag und Bekanntmachung des Hinweises auf die Patenterteilung:
**06.08.1997 Patentblatt 1997/32**

(51) Int Cl.$^6$: **H03F 3/30**, H03F 1/32

(21) Anmeldenummer: **91118795.3**

(22) Anmeldetag: **05.11.1991**

(54) **Ausgangsstufe für Verstärker**

Output stage for amplifier

Etage de sortie pour amplificateur

(84) Benannte Vertragsstaaten:
**BE DE ES FR GB IT NL**

(30) Priorität: **15.11.1990 DE 4036406**

(43) Veröffentlichungstag der Anmeldung:
**20.05.1992 Patentblatt 1992/21**

(73) Patentinhaber: **TEMIC TELEFUNKEN microelectronic GmbH**
**74072 Heilbronn (DE)**

(72) Erfinder:
• **Gutsch, Henrik, Dr.**
**W-7100 Heilbronn (DE)**

• **Rebmann, Volkmar**
**W-7100 Heilbronn (DE)**
• **Schnabel, Jürgen**
**W-7129 Ilsfeld (DE)**

(74) Vertreter: **Maute, Hans-Jürgen, Dipl.-Ing.**
**TEMIC TELEFUNKEN microelectronic GmbH**
**Postfach 35 35**
**74025 Heilbronn (DE)**

(56) Entgegenhaltungen:
FR-A- 2 424 665        GB-A- 2 033 688
US-A- 4 025 871        US-A- 4 295 101
US-A- 4 573 021        US-A- 5 019 789

**Beschreibung**

Die Erfindung betrifft eine Ausgangsstufe für Verstärker nach dem Oberbegriff des Patentanspruchs 1, wie sie aus der US 4 025 871 bekannt ist.

Verstärkerstufen, insbesondere Operationsverstärkerstufen, sind in der Regel mehrstufig aufgebaut; neben einer Differenz-Eingangsstufe und einer Ausgangsstufe oder Endstufe sind zwischen diesen beiden Stufen optional noch andere Verstärkerstufen vorhanden. Während die Eingangsstufe im wesentlichen zur Einstellung der Verstärkung dient, wird durch die Ausgangsstufe primär der Laststrom bereitgestellt, der je nach Einsatzzweck der Verstärkerstufe innerhalb eines großen Bereichs schwanken kann. Daneben sollte die Ausgangsstufe auch geringe Verzerrungen sowie einen geringen Ausgangswiderstand aufweisen und die Verstärkungseigenschaften der Verstärkerstufe nicht beeinträchtigen.

Um einen großen Ausgangsspannungshub zu gewährleisten, und um das Frequenzverhalten der Verstärkerstufe zu verbessern, werden sogenannte All-NPN-Ausgangsstufen eingesetzt, bei denen ausschließlich NPN-Transistoren für die Bereitstellung des Laststroms verantwortlich sind. Im Ruhezustand der Verstärkerstufe (kein Laststrom) fließt durch die Ausgangstransistoren ein geringer Querstrom; das Potential am Ausgang der Ausgangsstufe stellt sich auf ein Ruhepotential bzw. Gleichgewichts-Potential ein, das ungefähr der halben Versorgungsspannung entspricht. Bei Belastung soll ein Ausgangstransistor den zur Anhebung des Ausgangspotentials benötigten Strom liefern (positive Halbwelle), im Falle einer Absenkung des Ausgangspotentials soll ein anderer Transistor den nötigen Strom aufnehmen (negative Halbwelle). Dies wird dadurch realisiert, daß die Transistoren komplementär angesteuert werden; die dazu erforderlichen Verstärkerschaltungen weisen jedoch stark unterschiedliche Verstärkungseigenschaften auf. Die Ausgangstransistoren wechseln sich je nach Polarität der Ausgangsspannung in der Laststromführung ab, wobei beim Übergang von der positiven zur negativen Halbwelle der Ausgangsspannung die Ausgangstransistoren kurzzeitig stromlos werden können (nicht-ideale Stromübergabe), was zu einer Lücke in der übertragungs-Kennlinie führt. Durch den erwähnten Ruhequerstrom werden zwar derartige Lücken bei der Stromübergabe vermieden, jedoch bedingen die stark unterschiedlichen Verstärkungseigenschaften der Ausgangstransistoren starke Nicht-Linearitäten in der Übertragungs-Kennlinie, die vor allem im Bereich um den Gleichgewichts-Zustand zu einem scharfen Knick in der Kennlinie führen; dadurch werden aber auch die Übertragungseigenschaften der Verstärkerstufe, insbesondere bei kleinen Ausgangsspannungen, sehr stark beeinträchtigt (Verzerrungen, großer Klirrfaktor etc.). Um den Knick in der übertragungs-Kennlinie bei der Stromübergabe abzuschwächen, müssen die Verstärkungseigenschaften - insbesondere im Bereich des Gleichgewichts-Zustands - einander angeglichen werden.

Bei der aus der gattungsbildenden US 4 025 871 bekannten Ausgangsstufe eines Audioverstärkers ist die Gegenkopplung - unter Verwendung eines Transistors - als Strom-Spannungs-Gegenkopplung bzw. Seriell-Parallel-Gegenkopplung realisiert (abhängig vom Strom wird eine Spannung zur Gegenkopplung eingeprägt bzw. herangezogen); die Begrenzerschaltung begrenzt den zur Verfügung stehenden Nutzstrom für die Basis des Ausgangstransistors, der Gegenkopplungsstrom wird durch die Begrenzerschaltung nicht tangiert. Weiterhin wird in der US 5 019 789 eine Push-Pull-Ausgangsstufe mit einer anpaßbaren Vorspannung für die beiden NPN-Ausgangstransistoren der Ausgangsstufe beschrieben.

Der Erfindung liegt die Aufgabe zugrunde, eine Ausgangsstufe für Verstärker anzugeben, die auch bei kleinen Ausgangsspannungen gute Eigenschaften, insbesondere geringe Nicht-Linearitäten und geringe Verzerrungen aufweist.

Diese Aufgabe wird erfindungsgemäß durch die Merkmale des Patentanspruchs 1 gelöst.

Vorteilhafte Weiterbildungen der Erfindung ergeben sich aus den weiteren Patentansprüchen.

Gemäß der Erfindung wird der Basisstrom des Ausgangstransistors im Verstärkerzweig mit der größeren Verstärkung dadurch reduziert, daß durch eine - mittels mehrerer Transistoren realisierte - Stromgegenkopplungsschaltung ein zu seinem Emitterstrom proportionaler Strom von der Basis des Ausgangstransistors abgezogen wird. Zusätzlich wird durch die Begrenzerschaltung eine Begrenzung der Strom(-Strom-)Gegenkopplung auf den Übergangsbereich bzw. Übergabebereich der Übertragungs-Kennlinie dadurch vorgenommen, daß der von der Basis des Ausgangstransistors subtrahierte Strom auf einen bestimmten vorgebbaren Maximalwert beschränkt wird. Der Faktor der Stromgegenkopplung und der Bereich, in dem diese wirksam sein soll, können dabei beliebig durch geeignete Dimensionierung der beteiligten Schaltungskomponenten vorgegeben bzw. eingestellt werden.

Die Ausgangsstufe nach der Erfindung vereinigt mehrere Vorteile in sich:

- die Gegenkopplungsverstärkung ist genau und in einem großen Wertebereich einstellbar, daher kann auch bei kleinen Aussteuerungen eine hohe Linearität der Ausgangsstufe erreicht werden; durch die Gegenkopplung werden alle Arten von vorhandenen Nicht-Linearitäten in der Übertragungs-Kennlinie der Ausgangsstufe reduziert

- durch die Wahl der Flächenverhältnisse, Ströme und Widerstände der Gegenkopplungsschaltung und damit der Rückkopplungsfaktoren, sind viele Eingriffsmöglichkeiten für eine Optimierung der Verstärkerstufe vorhanden

- sie besitzt nur zwei laststromführende NPN-Ausgangstransistoren, die für den jeweiligen Laststrom dimensioniert werden müssen; alle anderen Transistoren, die nicht an der Laststromführung beteiligt sind, und die für die Stromgegenkopplung und die Strombegrenzung benötigt werden, können minimiert werden, so daß ein geringer Flächenbedarf besteht

- die Gegenkopplung verringert - insbesondere bei größeren Ausgangsleistungen - auch den Ruhestrom der Ausgangsstufe, wodurch dieser stabilisiert wird.

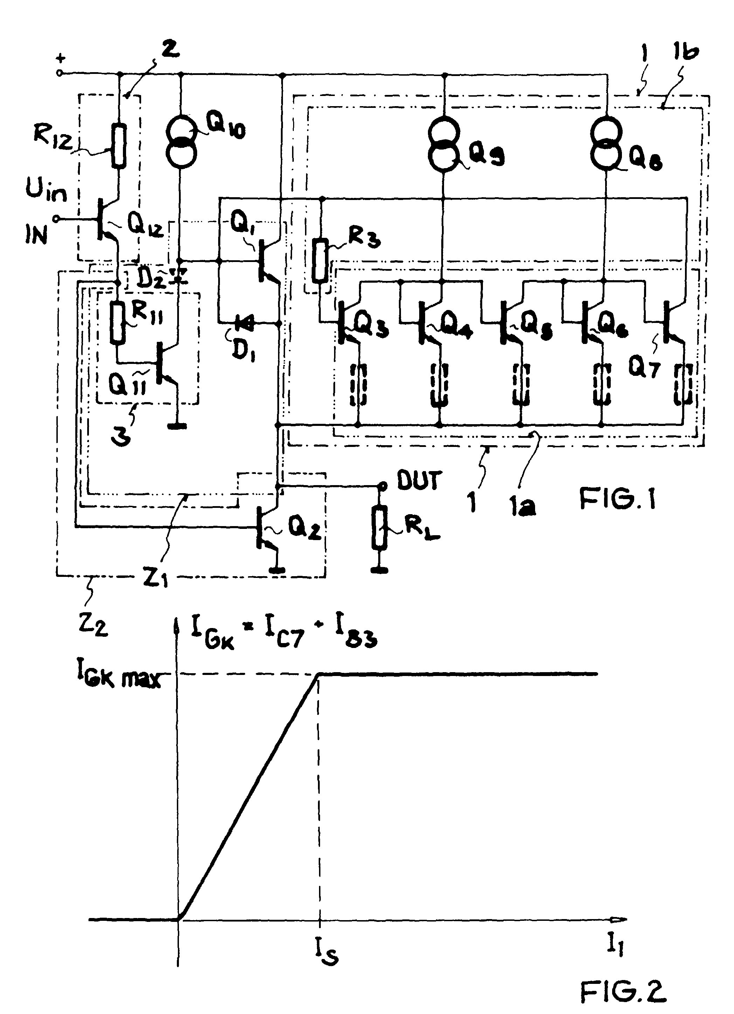

Die erfindungsgemäße Verstärkerstufe soll anhand eines Ausführungsbeispiels näher beschrieben werden. Dabei ist in der Figur 1 ein Schaltbild der Verstärkerstufe und in der Figur 2 der Verlauf des Gegenkopplungsstroms dargestellt, wobei dieser beispielsweise im Übergangsbereich einen linearen Verlauf aufweist.

Gemäß der Figur 1 weist die Ausgangsstufe zwei NPN-Ausgangstransistoren $Q_1$ und $Q_2$ in unterschiedlichen Verstärkerzweigen $Z_1$ und $Z_2$ auf. Die Ausgangstransistoren $Q_1$ und $Q_2$ sind derart an der Laststromführung beteiligt, daß der erste Ausgangstransistor $Q_1$ nur während der "positiven Halbwelle" der Ausgangsspannung und der zweite Ausgangstransistor $Q_2$ nur während der "negativen Halbwelle" Strom führt. Im Übergangsbereich bzw. Ruhezustand der Schaltung fließt durch beide Ausgangstransistoren ein Querstrom, der beispielsweise 5 % des maximalen Laststroms beträgt. Zur komplementären Ansteuerung der beiden Transistoren wird die Eingangsspannung $U_{IN}$ - die beispielsweise die Ausgangsspannung der Eingangsstufe oder einer anderen schalteten Verstärkerstufe ist - im ersten Verstärkerzweig $Z_1$ der Basis des ersten Ausgangstransistors $Q_1$ durch eine Emitterschaltung 3 und im zweiten Verstärkerzweig $Z_2$ der Basis des zweiten Ausgangstransistors $Q_2$ direkt zugeführt. Der vorgeschaltete Emitterfolger-Transistor $Q_{12}$ - Verstärkung $V = 1$, großer Eingangswiderstand, kleiner Ausgangswiderstand - an dessen Basis die Eingangsspannung $U_{IN}$ anliegt, und dessen Kollektor über den Begrenzerwiderstand $R_{12}$ an die Versorgungsspannung angeschlossen ist, dient als Pufferverstärker 2 zur Entkopplung der Ausgangsstufe von vorhergehenden Verstärkerstufen.

Der zweite Ausgangstransistor $Q_2$ wird direkt durch den Emitterfolger-Transistor $Q_{12}$ angesteuert und wirkt als durch den Ausgangs- bzw. Lastwiderstand $R_L$ belastete Emitterschaltung. Die Verstärkung $V_2$ des zweiten Verstärkerzweigs $Z_2$ (Ausgangstransistor $Q_2$) läßt sich damit folgendermaßen angeben:

$$V_2 = - k \cdot R_L = - \frac{I_{C2}}{U_T} \cdot R_L \qquad (1)$$

Hierbei ist k die Steilheit des Transistors $Q_2$, $R_L$ der Lastwiderstand, $I_{C2}$ der Kollektorstrom des Transistors $Q_2$ und $U_T$ die sogenannte Temperaturspannung. Die Verstärkung $V_2$ hängt somit stark vom (externen) Lastwiderstand $R_L$ und vom Kollektorstrom des Transistors $Q_2$ bzw. von dessen Ruhestrom ab und infolgedessen auch von der Aussteuerung der Verstärkerstufe.

Der erste Ausgangstransistor $Q_1$ wird von dem Emitterfolger 2 - Transistor $Q_{12}$ - und der Emitterschaltung 3 - Widerstand $R_{11}$, Steuertransistor $Q_{11}$ - angesteuert, wobei der Widerstand $R_{11}$ zur Begrenzung des Basisstroms von $Q_{11}$ und die am Kollektor des Transistors $Q_{11}$ angeschlossene Stromquelle $Q_{10}$ als Versorgung für die Transistoren $Q_{11}$ und $Q_1$ dient. Da der Ausgangstransistor $Q_1$ die Last des Steuertransistors $Q_{11}$ in Emitterschaltung darstellt und selbst hinsichtlich des Lastwiderstands $R_L$ als Emitterfolger wirkt, ergibt sich die Verstärkung $V_1$ des ersten Verstärkerzweigs $Z_1$ (Ausgangstransistor $Q_1$) zu:

$$V_1 = - \beta \cdot R_L \cdot \frac{I_{C11}}{U_T} \qquad (2)$$

Hierbei ist $\beta$ die Stromverstärkung des Ausgangstransistors $Q_1$ und $I_{C11}$ der Kollektorstrom des Transistors $Q_{11}$. Man erkennt aus Gleichung (2) zum einen, daß $V_1$ wegen des Faktors $\beta$ groß gegenüber $V_2$ ist, zum anderen, daß $V_1$ im Gegensatz zu $V_2$ (Gleichung 1) in erster Näherung unabhängig von der Aussteuerung ist.

Die Diode $D_2$, die zwischen dem Kollektor des Transistors $Q_{11}$ und der Basis des Transistors $Q_1$ angeschlossen ist, kann optional zur Entkopplung des Kollektors des Transistors $Q_{11}$ vom Ausgang eingesetzt werden, die Diode $D_1$ zwischen Basis und Emitter des Transistors $Q_1$ dient als Schutzdiode für diesen Transistor, um einen Spannungsdurchbruch von dessen Basis-Emitterdiode zu vermeiden.

Um die Verstärkung $V_1$ des ersten Ausgangstransistors $Q_1$ an den geringeren Wert $V_2$ anzugleichen, muß gemäß Gleichung (2) der Eingangswiderstand ($\beta \cdot R_L$) des Ausgangstransistors $Q_1$ reduziert werden, jedoch nur im Bereich des Gleichgewichts-Zustands der Ausgangsstufe. Dies wird durch eine Kombination aus Stromgegenkopplung und Strombegrenzung realisiert, wobei die Stromgegenkopplungsschaltung mit Begrenzung gemäß Figur 1 die Stromspiegel-Transistoren $Q_3$ - $Q_6$, den Auskopplungstransistor $Q_7$, die Stromquellen $Q_8$ und $Q_9$ sowie den Widerstand $R_3$ enthält.

Der gesamte Gegenkopplungsstrom $I_{Gk}$ setzt sich dabei aus dem Basisstrom $I_{B3}$ des ersten Stromspiegel-Transistors $Q_3$ und dem Kollektorstrom $I_{C7}$ des Auskopplungstransistors $Q_7$ zusammen. Durch die Stromspiegel-Transistoren $Q_3$, $Q_4$ und die Stromquelle $Q_9$ wird eine erste Stromdifferenzbildung, durch die Stromspiegel-Transistoren $Q_5$, $Q_6$ und die Stromquelle $Q_8$ eine zweite Stromdifferenzbildung zur Erzeugung eines zum Emitterstrom $I_1$ des ersten Ausgangstransistors $Q_1$ proportionalen Rückkopplungsstroms vorgenommen, der als Kollektorstrom $I_{C7}$ des Auskopplungstransistors $Q_7$ auf den Basiseingang des ersten Ausgangstransistors $Q_1$ wirkt.

Der Bereich, in dem die Gegenkopplung aktiv ist, kann durch den Widerstand $R_3$ und durch Wahl der Ströme der Stromquellen $Q_8$ und $Q_9$ eingestellt werden, indem durch den Widerstand $R_3$ und die beiden Stromquellen $Q_8$ und $Q_9$ eine Begrenzung des Rückkopplungsstroms $I_{Gk}$ auf einen Maximalwert vorgenommen wird. Der Widerstand $R_3$ begrenzt dabei den Basisstrom $I_{B3}$ und die Stromquellen $Q_8$ und $Q_9$ begrenzen den Kollektorstrom $I_{C7}$.

Die Faktoren der Stromgegenkopplung können durch die Dimensionierung der beteiligten Schaltungskomponenten beeinflußt werden:

a) Rückkopplungsstrom:

Der Betrag des Emitterstroms $I_1$ des Ausgangstransistors $Q_1$ wird mittels des ersten Stromspiegel-Transistors $Q_3$ bestimmt, wobei der Stromspiegel-Transistor $Q_3$ den Strom $I_1$ kopiert und - je nach Flächenverhältnis $A_1/A_3$ der Emitterflächen der Transistoren $Q_1$ und $Q_3$ - einen zum Strom $I_1$ proportionalen Strom $I_3 = I_1 \cdot A_3/A_1$ an die weitere Schaltung liefert.

Durch sukzessive Verwendung der Stromspiegel-Eigenschaft der Transistoren $Q_4$ bis $Q_6$, wird ein dem Strom $I_3$ und damit dem Strom $I_1$ proportionaler Strom $I_6$ am Kollektor des Transistors $Q_6$ erzeugt. Der Transistor $Q_7$ koppelt den Strom $I_6$ auf den Transistor $Q_1$ zurück; dieser Teil des Rückkopplungsstroms $I_{C7}$ - der neben dem Strom $I_{B3}$ vom Basisstrom des Transistors $Q_1$ subtrahiert wird - berechnet sich zu:

$$I_{C7} = k_{ges} \cdot I_1 \qquad (3)$$

mit

$$k_{ges} = \frac{A_3 \cdot A_5 \cdot A_7}{A_1 \cdot A_4 \cdot A_6} \qquad (4)$$

Die Faktoren $A_1$ und $A_3$ bis $A_7$ sind dabei die Emitterflächen der Transistoren $Q_1$ und $Q_3$ bis $Q_7$.

Wie sich aus den Gleichungen (3) und (4) ergibt, kann die Größe des Rückkopplungsstroms $I_{C7}$ und damit die gewünschte Reduzierung des Eingangswiderstands und folglich der Verstärkung $V_1$ des ersten Verstärkerzweigs $Z_1$ (Ausgangstransistor $Q_1$) durch Wahl der Emitter-Flächen $A_1$ und $A_3$ bis $A_7$ der Transistoren $Q_1$ und $Q_3$ bis $Q_7$ beliebig vorgegeben werden.

Eine andere Möglichkeit besteht darin, den Gegenkopplungsfaktor über einen oder mehrere Emitter-Widerstände der Transistoren $Q_3$ bis $Q_7$ zu beeinflussen.

b) Rückkopplungsbereich:

Die Begrenzerschaltung 1b soll dann aktiv werden, wenn der Übergabebereich verlassen wird, d. h. wenn der Ausgangsstrom der Verstärkerstufe einen bestimmten Schwellwert übersteigt; in diesem Fall soll von der Basis des Transistors $Q_1$ nur ein geringer konstanter Strom subtrahiert werden. Um den Eingriff der Gegenkopplung auf den Übergabebereich zu beschränken, werden der Widerstand $R_3$ und die beiden Stromquellen $Q_8$ und $Q_9$ folgendermaßen wirksam:

- $R_3$ begrenzt den Basisstrom $I_{B3}$ des Transistors $Q_3$ dann, wenn der Emitterstrom $I_1$ des Transistors $Q_1$ einen bestimmten Wert überschreitet, d. h. wenn der Übergabebereich verlassen wird; solange der Strom $I_1$ gering ist - i. e. im Übergabebereich - besitzt $R_3$ keine signifikante Funktion. Der Wert des maximalen Basisstroms $I_{B3max}$ ist näherungsweise durch die Relation $I_{B3max} \approx 150\ mV/R_3$ gegeben.

- Die beiden Stromquellen $Q_8$ und $Q_9$ begrenzen den Rückkopplungsstrom $I_{C7}$ auf einen vorgebbaren Maximalwert $I_{C7max}$. Es gilt: $I_9 = I_3 + I_4$ und daher $I_3 \leq I_9$, d. h. $I_{3max} = I_9$; weiterhin gilt: $I_8 = I_6 + I_5$, daher $I_6 = I_8 - I_5$, d. h. $I_6 \leq I_8$ und $I_{6max} = I_8$. Wegen $I_{C7} = I_6 \cdot A_7/A_6$ kann $I_{C7}$ maximal den Wert $I_{C7max} = I_8 \cdot A_7/A_6$ annehmen, wobei $I_8$ durch die beiden Stromquellen $Q_9$ und $Q_8$ gemäß der Beziehung $I_9 \cdot A_5 = I_8 \cdot A_4$ vorgegeben werden kann.

Dieses Prinzip der Begrenzerschaltung wird anhand der Figur 2 veranschaulicht; hier ist der Gegenkopplungsstrom $I_{Gk} = I_{C7} + I_{B3}$ als Funktion des Emitterstroms $I_1$ des ersten Ausgangstransistors $Q_1$ dargestellt. Solange die Gegenkopplung aktiv ist, steigt der Gegenkopplungsstrom $I_{Gk}$ im Übergangsbereich linear mit dem Strom $I_1$ an.

Die Begrenzerschaltung kommt bei einem bestimmten vorgebbaren Schwellwert $I_s$ - beispielsweise 100 µA - zum Tragen, bei größeren Stromwerten $I_1 > I_s$ wird von der Basis des ersten Ausgangstransistors $Q_1$ der konstante Strom $I_{Gkmax} = I_{C7max} + I_{B3max}$ abgezogen, der unabhängig von $I_1$ ist und von $R_3$ und $Q_8$ bzw. $Q_9$ abhängt.

Einsetzen läßt sich die erfindungsgemäße Verstärker-Ausgangsstufe u. a. in NF-Verstärkern, beispielsweise im Telecom-Bereich, HiFi-Bereich, in der Unterhaltungselektronik oder in Funksprechgeräten.

Bei einer Anwendung als Leitungsverstärker in einem Telefonsystem - mit einem maximalen Wechselstrom von 5 mA und einem Ruhestrom von 500 µA - wurde beispielsweise für den Rückkopplungsfaktor $k_{ges} = \frac{1}{2}$ gewählt, und für die Schwellwert-Ströme $I_8$ 20 µA und $I_{B3max}$ ca. 15 µA eingestellt.

Bei einer anderen Anwendung in Mikrofon-Verstärkern - mit einem maximalen Wechselstrom von 1 mA und einem Ruhestrom von 300 µA - wurde für den Rückkopplungsfaktor $k_{ges}$ = 8 gewählt, und für die Schwellwert-Ströme $I_8$ 40 µA und $I_{B3max}$ ca. 40 µA eingestellt.

**Patentansprüche**

1. Ausgangsstufe für Verstärker, mit zwei laststromführenden NPN-Ausgangstransistoren ($Q_1$, $Q_2$) in unterschiedlichen Verstärkerzweigen ($Z_1$, $Z_2$) mit unterschiedlichen Verstärkungseigenschaften ($V_1$, $V_2$), wobei dem ersten Ausgangstransistor ($Q_1$) mit der größeren Verstärkung, der sich im Verstärkerzweig ($Z_1$) mit der größeren Verstärkung befindet, Mittel (1) zur Stromgegenkopplung (1a) und Strombegrenzung (1b) nachgeschaltet sind, dadurch gekennzeichnet, daß zur Beeinflussung der Verstärkungseigenschaften des ersten Ausgangstransistors ($Q_1$) eine aus mehreren Transistoren bestehende Stromgegenkopplungsschaltung (1a) vorgesehen ist, durch die ein Gegenkopplungsstrom ($I_{Gk}$) erzeugt und von der Basis des ersten Ausgangstransistors ($Q_1$) abgezogen wird, und daß durch eine Begrenzerschaltung (1b) der Gegenkopplungsstrom ($I_{GK}$) auf einen vorgebbaren Maximalwert ($I_{Gkmax}$) derart begrenzt wird, daß die Verstärkungseigenschaften des ersten Ausgangstransistors ($Q_1$) in einem bestimmten vorgebbaren Bereich des Ausgangsstroms der Verstärkerstufe beeinflußt werden.

2. Ausgangsstufe nach Anspruch 1, dadurch gekennzeichnet, daß die Stromgegenkopplungsschaltung (1a) hintereinander geschaltete Stromspiegel-Transistoren ($Q_3$ - $Q_7$) enthält, von denen einer als Auskopplungstransistor ($Q_7$) dient, daß die Emitter und die Basen des ersten Ausgangstransistors ($Q_1$) und eines ersten Stromspiegel-Transistors ($Q_3$) direkt oder über einen oder mehrere Widerstände ($R_3$) verbunden sind, so daß ein erster Teil des Gegenkopplungsstroms ($I_{Gk}$) durch den Basisstrom ($I_{B3}$) des ersten Stromspiegel-Transistors ($Q_3$) gegeben ist, daß der Betrag des Emitterstroms ($I_1$) des ersten Ausgangstransistors ($Q_1$) durch den ersten Stromspiegel-Transistor ($Q_3$) bestimmt wird, daß die Emitter der weiteren Stromspiegel-Transistoren ($Q_4$ - $Q_6$) und des Auskopplungstransistors ($Q_7$) miteinander verbunden sind, so daß ein lineares Vielfaches des Emitterstroms ($I_1$) des ersten Ausgangstransistors ($Q_1$) als Kollektorstrom ($I_{CZ}$) des Auskopplungstransistors ($Q_7$) gebildet wird, und daß der Kollektor des Auskopplungstransistors ($Q_7$) mit der Basis des ersten Ausgangstransistors ($Q_1$) verbunden ist, so daß ein zweiter Teil des Gegenkopplungsstroms ($I_{GK}$), der vom Basisstrom des ersten Ausgangstransistors ($Q_1$) subtrahiert wird,

durch den Kollektorstrom ($I_{C7}$) des Auskopplungstransistors ($Q_7$) gegeben ist.

3. Ausgangsstufe nach Anspruch 1 oder 2, dadurch gekennzeichnet, daß der Betrag des zweiten Teils ($I_{C7}$) des Gegenkopplungsstroms ($I_{Gk}$) durch die Emitterflächen ($A_3$ - $A_7$) der Stromspiegel-Transistoren ($Q_3$ - $Q_7$) bestimmt ist.

4. Ausgangsstufe nach einem der Ansprüche 1 bis 3, dadurch gekennzeichnet, daß die Begrenzerschaltung (1b) einen Begrenzerwiderstand ($R_3$) und zwei Stromquellen ($Q_8$, $Q_9$) aufweist.

5. Ausgangsstufe nach Anspruch 4, dadurch gekennzeichnet, daß der erste Anschluß des Begrenzerwiderstands ($R_3$) mit der Basis des ersten Ausgangstransistors ($Q_1$) und der andere Anschluß mit der Basis des ersten Stromspiegel-Transistors ($Q_3$) verbunden ist, so daß der Basisstrom ($I_{B3}$) des ersten Stromspiegel-Transistors ($Q_3$) auf einen durch den Begrenzerwiderstand ($R_3$) vorgebbaren Maximalwert ($I_{B3max}$) begrenzt wird.

6. Ausgangsstufe nach Anspruch 4, dadurch gekennzeichnet, daß die erste Stromquelle ($Q_9$) mit den Kollektoren des ersten Stromspiegel-Transistors ($Q_3$) und eines zweiten Stromspiegel-Transistors ($Q_4$) und mit der Basis eines dritten Stromspiegel-Transistors ($Q_5$) verbunden ist, daß die zweite Stromquelle ($Q_8$) mit den Kollektoren eines dritten und eines vierten Stromspiegel-Transistors ($Q_5$, $Q_6$) und mit der Basis des Auskopplungstransistors ($Q_7$) verbunden ist, so daß durch eine erste Stromdifferenzbildung ($Q_3$, $Q_4$ und $Q_9$) und durch eine zweite Stromdifferenzbildung ($Q_5$, $Q_6$ und $Q_8$) der Kollektorstrom ($I_{C7}$) des Auskopplungstransistors ($Q_7$) auf einen durch die beiden Stromquellen ($Q_8$, $Q_9$) vorgebbaren Maximalwert begrenzt wird.

7. Ausgangsstufe nach einem der Ansprüche 1 bis 6, dadurch gekennzeichnet, daß im Emitterzweig von einem oder von mehreren Stromspiegel-Transistor (en) ($Q_3$ - $Q_7$) Emitterwiderstände angeordnet sind.

8. Ausgangsstufe nach einem der Ansprüche 1 bis 7, dadurch gekennzeichnet, daß am Eingang (IN) der Ausgangsstufe ein Emitterfolger (2) als Pufferverstärker vorgesehen ist, und daß an der Basis eines Pufferverstärker-Transistors ($Q_{12}$) des Pufferverstärkers die Eingangsspannung ($U_{IN}$) anliegt.

9. Ausgangsstufe nach einem der Ansprüche 1 bis 8, dadurch gekennzeichnet, daß der Emitter des Pufferverstärker-Transistors ($Q_{12}$) mit der Basis des zweiten Ausgangstransistors ($Q_2$) direkt und mit der Basis des ersten Ausgangstransistors ($Q_1$) über eine Emitterschaltung (3) verbunden ist.

**10.** Ausgangsstufe nach einem der Ansprüche 1 bis 9, dadurch gekennzeichnet, daß die Basis des ersten Ausgangstransistors ($Q_1$) mit einer dritten Stromquelle ($Q_{10}$) verbunden ist.

**11.** Ausgangsstufe nach einem der Ansprüche 1 bis 10, dadurch gekennzeichnet, daß eine externe Last ($R_L$) am Schaltungsausgang (OUT) angeschlossen ist, der durch den Emitter des ersten Ausgangstransistors ($Q_1$) und den Kollektor des zweiten Ausgangstransistors ($Q_2$) gebildet ist.

**12.** Ausgangsstufe nach einem der Ansprüche 1 bis 11, dadurch gekennzeichnet, daß die Basis und der Emitter des ersten Ausgangstransistors ($Q_1$) über eine erste Diode ($D_1$) miteinander verbunden sind.

**13.** Ausgangsstufe nach einem der Ansprüche 1 bis 12, dadurch gekennzeichnet, daß der Kollektor eines Emitterschaltungs-Transistors ($Q_{11}$) der Emitterschaltung (3) und die Basis des ersten Ausgangstransistors ($Q_1$) über eine zweite Diode ($D_2$) miteinander verbunden sind.

**14.** Ausgangsstufe nach einem der Ansprüche 1 bis 13, dadurch gekennzeichnet, daß die Ausgangsstufe in einer Integrierten Schaltung integriert ist.

**15.** Ausgangsstufe nach Anspruch 1 zur Verwendung in einem NF-Verstärker.

**Claims**

**1.** An output stage for amplifiers, comprising two load-current-carrying NPN output transistors ($Q_1$, $Q_2$) in different amplifier arms ($Z_1$, $Z_2$) having different amplification properties ($V_1$, $V_2$), wherein downstream of the first output transistor ($Q_1$) with the greater amplification arranged in the amplifier arm ($Z_1$) with the greater amplification there are arranged means (1) for current negative feedback (1a) and current limitation (1b), characterised in that in order to influence the amplification properties of the first output transistor ($Q_1$) a current negative feedback circuit (la) is provided which comprises a plurality of transistors and by means of which a negative feedback current ($I_{Gk}$) is generated and subtracted from the base of the first output transistor ($Q_1$), and that by means of a limiter circuit (1b) the negative feedback current ($I_{Gk}$) is limited to a predeterminable maximum value ($I_{Gkmax}$) such that the amplification properties of the first output transistor ($Q_1$) are influenced in a specified, predeterminable range of the output current of the amplifier stage.

**2.** An output stage according to Claim 1, characterised in that the current negative feedback circuit (la) comprises series-connected current mirror transistors ($Q_3$ - $Q_7$), of which one serves as coupling-out transistor ($Q_7$), that the emitters and bases of the first transistor ($Q_1$) and of a first current mirror transistor ($Q_3$) are connected directly or via one or more resistor(s) ($R_3$), so that a first part of the negative feedback current ($I_{Gk}$) is formed by the base current ($I_{B3}$) of the first current mirror transistor ($Q_3$), that the amount of the emitter current ($I_1$) of the first output transistor ($Q_1$) is determined by the first current mirror transistor ($Q_3$), that the emitters of the further current mirror transistors ($Q_4$ - $Q_6$) and of the coupling-out transistor ($Q_7$) are connected to one another, so that a linear multiple of the emitter current ($I_1$) of the first output transistor ($Q_1$) is formed as collector current ($I_{CZ}$) of the coupling-out transistor ($Q_7$), and that the collector of the coupling-out transistor ($Q_7$) is connected to the base of the first output transistor ($Q_1$) so that a second part of the negative feedback current ($I_{Gk}$), which is subtracted from the base current of the first output transistor ($Q_1$), is formed by the collector current ($I_{C7}$) of the coupling-out transistor ($Q_7$).

**3.** An output stage according to Claim 1 or 2, characterised in that the amount of the second part ($I_{C7}$) of the negative feedback current ($I_{Gk}$) is determined by the emitter surfaces ($A_3$ - $A_7$) of the current mirror transistors ($Q_3$ - $Q_7$).

**4.** An output stage according to one of Claims 1 to 3, characterised in that the limiter circuit (1b) comprises a limiter resistor ($R_3$) and two current sources ($Q_8$, $Q_9$).

**5.** An output stage according to Claim 4, characterised in that the first terminal of the limiter resistor ($R_3$) is connected to the base of the first output transistor ($Q_1$) and the other terminal thereof is connected to the base of the first current mirror transistor ($Q_3$), so that the base current ($I_{B3}$) of the first current mirror transistor ($Q_3$) is limited to a maximum value ($I_{B3max}$) predeterminable by the limiter resistor ($R_3$).

**6.** An output stage according to Claim 4, characterised in that the first current source ($Q_9$) is connected to the collectors of the first current mirror transistor ($Q_3$) and of a second current mirror transistor ($Q_4$) and to the base of a third current mirror transistor ($Q_5$), that the second current source ($Q_8$) is connected to the collectors of a third and a fourth current mirror transistor ($Q_5$, $Q_6$) and to the base of the coupling-out transistor ($Q_7$), so that by means of a first current difference formation ($Q_3$, $Q_4$ and $Q_9$) and by means of a second current difference formation ($Q_5$, $Q_6$ and $Q_8$) the collector current ($I_{C7}$) of the coupling-out transistor ($Q_7$) is limited to a maximum value predeterminable by the two current sources

$(Q_8, Q_9)$.

7. An output stage according to one of Claims 1 to 6, characterised in that emitter resistors are arranged in the emitter arm of one or several current mirror transistor(s) $(Q_4 - Q_7)$.

8. An output stage according to one of Claims 1 to 7, characterised in that an emitter follower (2) is arranged as buffer amplifier at the input (IN) of the output stage and that the input voltage $(U_{IN})$ is applied to the base of a buffer amplifier transistor $(Q_{12})$ of the buffer amplifier.

9. An output stage according to one of Claims 1 to 8, characterised in that the emitter of the buffer amplifier transistor $(Q_{12})$ is connected to the base of the second output transistor $(Q_2)$ directly and is connected to the base of the first output transistor $(Q_1)$ via an emitter circuit (3).

10. An output stage according to one of Claims 1 to 9, characterised in that the base of the first output transistor $(Q_1)$ is connected to a third current source $(Q_{10})$.

11. An output stage according to one of Claims 1 to 10, characterised in that an external load $(R_L)$ is connected to the circuit output (OUT), which load $(R_L)$ is formed by the emitter of the first output transistor $(Q_1)$ and the collector of the second output transistor $(Q_2)$.

12. An output stage according to one of Claims 1 to 11, characterised in that the base and the emitter of the first output transistor $(Q_1)$ are connected to one another via a first diode $(D_1)$.

13. An output stage according to one of Claims 1 to 12, characterised in that the collector of an emitter circuit transistor $(Q_{11})$ of the emitter circuit (3) and the base of the first output transistor $(Q_1)$ are connected to one another via a second diode $(D_2)$.

14. An output stage according to one of Claims 1 to 13, characterised in that the output stage is integrated in an integrated circuit.

15. An output stage according to Claim 1 for use in a LF-amplifier.

**Revendications**

1. Etage de sortie pour amplificateur comprenant deux transistors de sortie NPN $(Q_1, Q_2)$ conduisant le courant de charge dans des branches d'amplificateur différentes $(Z_1, Z_2)$ de propriétés d'amplification différentes $(V_1, V_2)$, en aval du premier transistor de sortie $(Q_1)$ avec la plus grande amplification, qui se trouve dans la branche d'amplificateur $(Z_1)$ avec la plus grande amplification, des moyens (1) étant disposés pour une contre-réaction de courant (1a) et une limitation de courant (1b), caractérisé en ce qu'en vue d'influencer les propriétés d'amplification du premier transistor de sortie $(Q_1)$ est prévu un circuit de contre-réaction de courant (la) se composant de plusieurs transistors, par lequel est généré un courant de contre-réaction $(I_{Gk})$ et est prélevé de la base du premier transistor de sortie $(Q_1)$, et en ce que grâce à un circuit limiteur (1b), le courant de contre-réaction $(I_{Gk})$ est limité à une valeur maximale prédéterminée $(I_{Gkmax})$, de telle sorte que les propriétés d'amplification du premier transistor de sortie $(Q_1)$ sont influencées dans une plage déterminée pouvant être prescrite du courant de sortie de l'étage amplificateur.

2. Etage de sortie selon la revendication 1, caractérisé en ce que le circuit de contre-réaction (1a) contient des transistors miroirs de courant $(Q_3-Q_7)$ montés en succession, dont l'un sert de transistor de découplage $(Q_7)$, en ce que les émetteurs et les bases du premier transistor de sortie $(Q_1)$ et d'un premier transistor miroir de courant $(Q_3)$ sont réunis directement ou par l'intermédiaire d'une ou de plusieurs résistances $(R_3)$, de sorte qu'une première partie du courant de contre-réaction $(I_{Gk})$ est constituée par le courant de base $(I_{B3})$ du premier transistor miroir de courant $(Q_3)$, en ce que l'intensité du courant d'émetteur $(I_1)$ du premier transistor de sortie $(Q_1)$ est déterminée par le premier transistor miroir de courant $(Q_3)$, en ce que les émetteurs des autres transistors miroirs de courant $(Q_4-Q_6)$ et du transistor de découplage $(Q_7)$ sont réunis entre eux, de sorte qu'un multiple linéaire du courant d'émetteur $(I_1)$ du premier transistor de sortie $(Q_1)$ est formé en tant que courant de collecteur $(I_{C7})$ du transistor de découplage $(Q_7)$, et en ce que le collecteur du transistor de découplage $(Q_7)$ est relié à la base du premier transistor de sortie $(Q_1)$, de sorte qu'une seconde partie du courant de contre-réaction $(I_{Gk})$, qui est retranchée du courant de base du premier transistor de sortie $(Q_1)$, est délivrée par le courant de collecteur $(I_{C7})$ du transistor de découplage $(Q_7)$.

3. Etage de sortie selon la revendication 1 ou 2, caractérisé en ce que l'intensité de la seconde partie $(I_{C7})$ du courant de contre-réaction $(I_{Gk})$ est déterminée par les surfaces d'émetteurs $(A_3-A_7)$ des transistors miroirs de courant $(Q_3-Q_7)$.

4. Etage de sortie selon l'une quelconque des revendications 1 à 3, caractérisé en ce que le circuit limiteur (1b) comporte une résistance limiteuse $(R_3)$ et deux sources de courant $(Q_8, Q_9)$.

**5.** Etage de sortie selon la revendication 4, caractérisé en ce que la première borne de la résistance limiteuse ($R_3$) est reliée à la base du premier transistor de sortie ($Q_1$) et l'autre borne est reliée à la base du premier transistor miroir de courant ($Q_3$), de sorte que le courant de base ($I_{B3}$) du premier transistor miroir de courant ($Q_3$) est limité à une valeur maximale ($I_{B3max}$) prescrite par la résistance limiteuse ($R_3$).

**6.** Etage de sortie selon la revendication 4, caractérisé en ce que la première source de courant ($Q_9$) est reliée aux collecteurs du premier transistor miroir de courant ($Q_3$) et d'un second transistor miroir de courant ($Q_4$) et à la base d'un troisième transistor miroir de courant ($Q_5$), en ce que la seconde source de courant ($Q_8$) est reliée aux collecteurs d'un troisième et d'un quatrième transistors miroirs de courant ($Q_5$, $Q_6$) et à la base du transistor de découplage ($Q_7$), de sorte que, par une première formation de différence de courant ($Q_3$, $Q_4$ et $Q_9$) et par une seconde formation de différence de courant ($Q_5$, $Q_6$ et $Q_8$), le courant de collecteur ($I_{C7}$) du transistor de découplage ($Q_7$) est limité à une valeur maximale pouvant être prescrite par les deux sources de courant ($Q_8$, $Q_9$).

**7.** Etage de sortie selon l'une quelconque des revendications 1 à 6, caractérisé en ce que, dans la branche d'émetteur d'un ou de plusieurs transistors miroirs de courant ($Q_3$-$Q_7$) sont disposées des résistances d'émetteur.

**8.** Etage de sortie selon l'une quelconque des revendications 1 à 7, caractérisé en ce qu'à l'entrée (IN) de l'étage de sortie est prévu un circuit à émetteur asservi (2) en tant qu'amplificateur-tampon, et en ce qu'à la base d'un transistor amplificateur-tampon ($Q_{12}$) de l'amplificateur-tampon est appliquée la tension d'entrée ($U_{IN}$).

**9.** Etage de sortie selon l'une quelconque des revendications 1 à 8, caractérisé en ce que l'émetteur du transistor amplificateur-tampon ($Q_{12}$) est relié directement à la base du deuxième transistor de sortie ($Q_2$) et à la base du premier transistor de sortie ($Q_1$) par l'intermédiaire d'un circuit d'émetteur (3).

**10.** Etage de sortie selon l'une quelconque des revendications 1 à 9, caractérisé en ce que la base du premier transistor de sortie ($Q_1$) est reliée à une troisième source de courant ($Q_{10}$).

**11.** Etage de sortie selon l'une quelconque des revendications 1 à 10, caractérisé en ce qu'une charge extérieure ($R_L$) est reliée à la sortie du circuit (OUT), qui est formée par l'émetteur du premier transistor de sortie ($Q_1$) et le collecteur du deuxième transistor

de sortie ($Q_2$).

**12.** Etage de sortie selon l'une quelconque des revendications 1 à 11, caractérisé en ce que la base et l'émetteur du premier transistor de sortie ($Q_1$) sont réunis par l'intermédiaire d'une première diode ($D_1$).

**13.** Etage de sortie selon l'une quelconque des revendications 1 à 12, caractérisé en ce que le collecteur d'un transistor en montage à émetteur commun ($Q_{11}$) du circuit à émetteur commun (3) et la base du premier transistor de sortie ($Q_1$) sont réunis par l'intermédiaire d'une deuxième diode ($D_2$).

**14.** Etage de sortie selon l'une quelconque des revendications 1 à 13, caractérisé en ce que l'étage de sortie est intégré dans un circuit intégré.

**15.** Etage de sortie selon la revendication 1 en vue de l'utilisation dans un amplificateur audio-fréquence.

FIG.1

$$I_{GK} = I_{C7} + I_{B3}$$

FIG.2